Europäisches Patentamt

European Patent Office

Office européen des brevets

Publication number: **0 274 263**
**A2**

**EUROPEAN PATENT APPLICATION**

(21) Application number: **87311248.6**

(22) Date of filing: **21.12.87**

(51) Int. Cl.⁴ **F17C 3/08 , H05K 7/20**

(30) Priority: **07.01.87 US 1236**

(43) Date of publication of application:
**13.07.88 Bulletin 88/28**

(84) Designated Contracting States:
**DE FR GB**

(71) Applicant: **ETA SYSTEMS, INC.**
**1450 Energy Park Drive**
**St. Paul, MN 55108(US)**

(72) Inventor: **Sullivan, Daniel Cornalius**
**1100 50th Avenue, NW**
**Columbia Heights Minnesota 55421(US)**
Inventor: **Mazorol, Earl Allen**
**10006 Beard Avenue South**
**Bloomington Minnesota 55431(US)**

(74) Representative: **Caro, William Egerton et al**
**J. MILLER & CO. Lincoln House 296-302 High**
**Holborn**
**London WC1V 7JH(GB)**

(54) Cryostat and cryogenically cooled computer system.

(57) A cryostat comprises an outer shell (20) having a side wall (28) and a closed bottom (26), and an inner shell (22) positioned within the outer shell (20), the inner shell having a side wall (32), a closed bottom (30) and an open top. A connection (36,38) connects the inner and outer shells (20,22) to define a vacuum chamber (40) therebetween. An inner shell top plate (34) covers the open top end of the inner shell (22) and has a first opening (47A,47B) therein. A first containment vessel (24A,24B) is mounted below the inner shell top plate (34) and within an interior of the inner shell (22) for receiving a first device (12A,12B) to be cooled. A supply system (70,72) is connected to the first containment vessel (24A,24B) for supplying liquid cryogenic coolant thereto. A suspension device (16A,16B) suspends the device (12A,12B) in the first containment vessel while covering the first opening (47A,47B) and while providing transmission of signals to and from the first device.

Fig.1

# CRYOSTAT AND CRYOGENICALLY COOLED COMPUTER SYSTEM

This invention relates to cryostats and to cryogenically cooled computer systems.

The performance of certain electrical or electronic devices can be altered, and in fact enhanced, by operation at cryogenic temperature. Cryostats have been developed to permit operation of such devices at the extremely low temperature which is required. Examples of prior art cryostats are illustrated in US-A-3,122,004, US-A-3,133,144 and US-A-4,502,296. In general, these devices use a Dewar type construction, with an inner vessel and an outer vessel which are connected together to define a vacuum chamber. The inner vessel contains the cryogenic coolant (for example, liquid nitrogen or liquid helium) used to cool the particular electrical or electronic device. The vacuum maintained between the inner and outer vessels provides thermal insulation between the cryogenic coolant within the inner vessel and ambient room temperature outside the outer vessel.

As the computing power of computers has been increased, the demand for increasingly higher operating speeds of integrated circuits of the computer central processor has presented a significant technical challenge. One approach for achieving higher speeds is to use a semiconductor material (such as gallium arsenide) which is capable of yielding higher operating speed devices than is silicon. The disadvantage of this approach, however, is that material growth and integrated circuit fabrication techniques are far more advanced for silicon than for any other semiconductor material.

An alternative approach which offers significant increases in speed while making use of silicon integrated circuits involves the use of very large scale CMOS gate arrays which are operated at cryogenic temperatures. By operating the CMOS devices at the temperature of liquid nitrogen (77°K) rather than room temperature, approximately a two-to-one gain in operating speed of the circuits can be achieved.

In order to obtain the full advantage of this speed increase, the entire central processor must be operated at the cryogenic temperature. On the other hand, other circuits with which the central processor interacts (such as a central processor memory) do not require cooling to cryogenic temperatures. It is important to minimise the number of components to be cooled to cryogenic temperature because each watt of energy removed in the cooling process requires a significant expenditure of energy (and thus cost). Typically ten watts of power are expended for each watt of energy removed by cryogenic cooling.

The cooling of a central processor, therefore, presents significant technical challenges. Among them is the need to provide high speed signal transmission between the central processor and its associated central processor memory and this requires that the transmission paths between the central processor and the central processor memory circuit boards be very short. This, however, conflicts with the need to maintain as much thermal isolation as possible between an inner vessel containing liquid nitrogen and the surrounding environment which is at room temperature.

According to one aspect of the present invention there is provided a cryostat characterised by comprising: an outer shell having a side wall and a closed bottom; an inner shell positioned within the outer shell, the inner shell having a side wall, a closed bottom and an open top; connecting means for connecting the inner and outer shells to define a vacuum chamber therebetween; an inner shell top plate covering the open top end of the inner shell and having a first opening therein; a first containment vessel mounted below the inner shell top plate and within an interior of the inner shell for receiving a first device to be cooled; supply means connected to the first containment vessel for supplying liquid cryogenic coolant thereto; and suspension means for suspending the device in the first containment vessel while covering the first opening and while providing transmission of signals to and from the first device.

The outer shell and inner shell may be cylinders of generally circular cross-section.

The outer shell and the inner shell may be substantially concentrically positioned.

The containment vessel may be of substantially rectangular cross-section.

In one embodiment the device to be cooled is a circuit board having first and second generally parallel major surfaces, the first containment vessel having first and second side walls which are generally parallel to the first and second major surfaces of the circuit board.

Preferably the connecting means is a thermal isolation ring which extends between the outer shell and the inner shell. The thermal isolation ring, in one embodiment, is connected at its upper end to the outer shell and is connected at its lower end to the inner shell.

Preferably an outer shell top plate mounted on the outer shell and covering a top end of the outer shell, the outer shell top plate having a first opening positioned over the first opening in the inner shell top plate. Thus there may be provided a cavity between the first opening of the outer shell top plate and the first opening of the inner shell top plate for receiving the suspension means. Thermal insulation means may be positioned between the outer top shell plate and the inner shell top plate and generally surrounding the cavity.

In one embodiment the suspension means includes a cover, means extending through the cover for providing transmission of signals to and from the device; and mounting means for attaching the cover to the inner shell top plate to cover the first opening. The mounting means may comprise a plurality of bolts, each bolt having an upper end with a head, a lower end with a threaded shank and a thermally insulating sleeve connecting the upper end and the lower end. Preferably the means for providing transmission of signals is a seal board which extends through and is sealed to the cover, and is connected at its lower end to an upper end of the device.

The supply means may comprise an inlet coupling exposed at an exterior of the cryostat, and means extending from the inlet coupling through the inner shell to the first containment vessel. Thus there may be provided a pants leg surrounding and sealed to the inlet coupling at a first end and connected at a second end to the side wall of the outer shell.

The cryostat may include overflow vent means for providing a passage for the coolant from the first containment vessel to the interior of the inner shell, and drain means connected to the inner shell to remove coolant from therewithin.

In a preferred embodiment the cryostat has a second opening in the inner shell top plate substantially parallel to the first opening, a second containment vessel mounted below the inner shell top plate and within the interior of the inner shell for receiving a second device to be cooled, the supply means being connected to the second containment vessel for supplying liquid cryogenic coolant thereto, and second mounting means for suspending the second device to be cooled in the second containment vessel while covering the second opening and while providing transmission of signals to and from the second device.

According to a further aspect of the present invention there is provided a cryogenically cooled computer system characterised by comprising: a central processor circuit board having a plurality of integrated circuits mounted thereon which form a computer central processor; a central processor memory having a plurality of memory elements which are associated with the central processor; a cryostat having a containment vessel for receiving the central processor circuit board and having inlet supply means for supplying liquid cryogenic coolant to the containment vessel to cool the central processor circuit board to a cryogenic temperature; and mounting means connected to the central processor circuit board and the central processor memory for suspending the central processor circuit board within the containment vessel, the mounting means including means for sealing the containment vessel from the exterior of the cryostat, means for providing transmission of signals between the central processor circuit board and the central processor memory, and power feed-through means for providing electrical power to the central processor circuit board.

The cryostat preferably includes an outer shell, an inner shell position within the outer shell, and connecting means for connecting the inner and outer shells to define a vacuum chamber therebetween, the containment vessel being mounted within an interior of the inner shell.

The integrated circuits may be CMOS integrated circuits.

The invention is illustrated, merely by way of example, in the accompanying drawings, in which:-

Figure 1 is a perspective view of a cryostat according to the present invention with central processor boards mounted therein;

Figure 2 is a top view of the cryostat of Figure 1, with the central processor boards removed;

Figure 3 is a view taken along section 3-3 of Figure 2;

Figure 4 is a view taken along section 4-4 of Figure 3;

Figure 5 is a view taken along section 5-5 of Figure 3;

Figure 6 is a view taken along section 6-6 of Figure 5;

Figure 7 is a view taken along section 7-7 of Figure 5;

Figure 8 is a view taken along section 8-8 of Figure 5;

Figure 9 is a view taken along section 9-9 of Figure 5;

Figure 10 is a view taken along section 10-10 of Figure 1;

Figure 11 is a view taken along section 11-11 of Figure 1; and

Figure 12 shows a hold down bolt used in clamping a cover to an inner shell top plate of the cryostat of Figure 1.

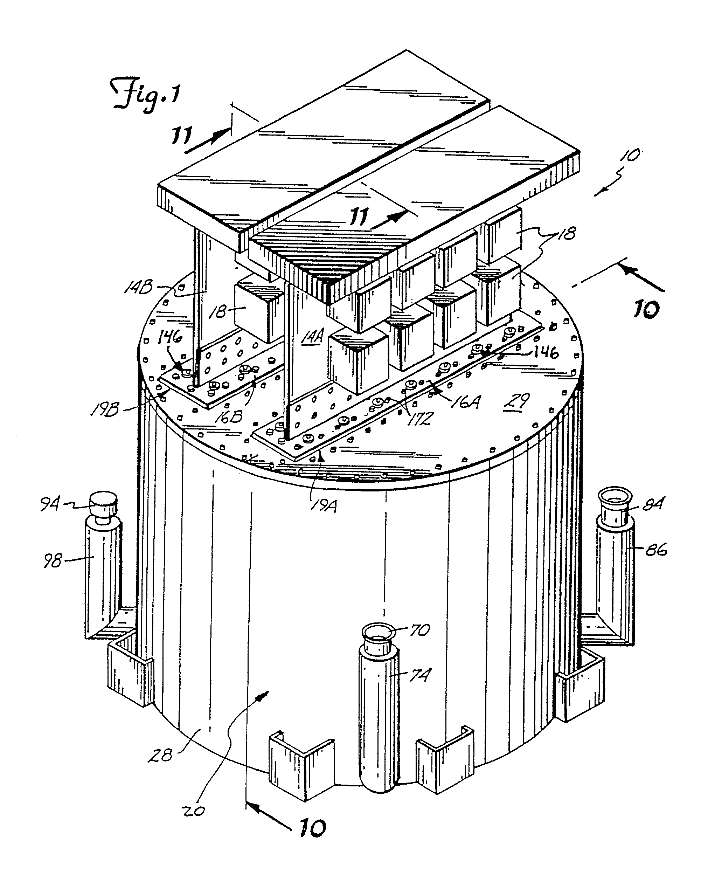

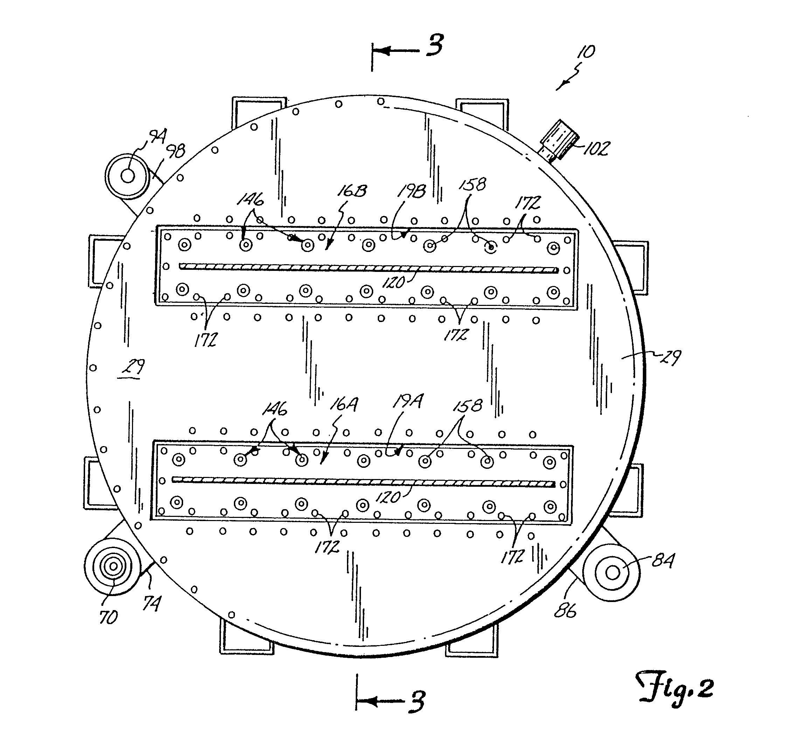

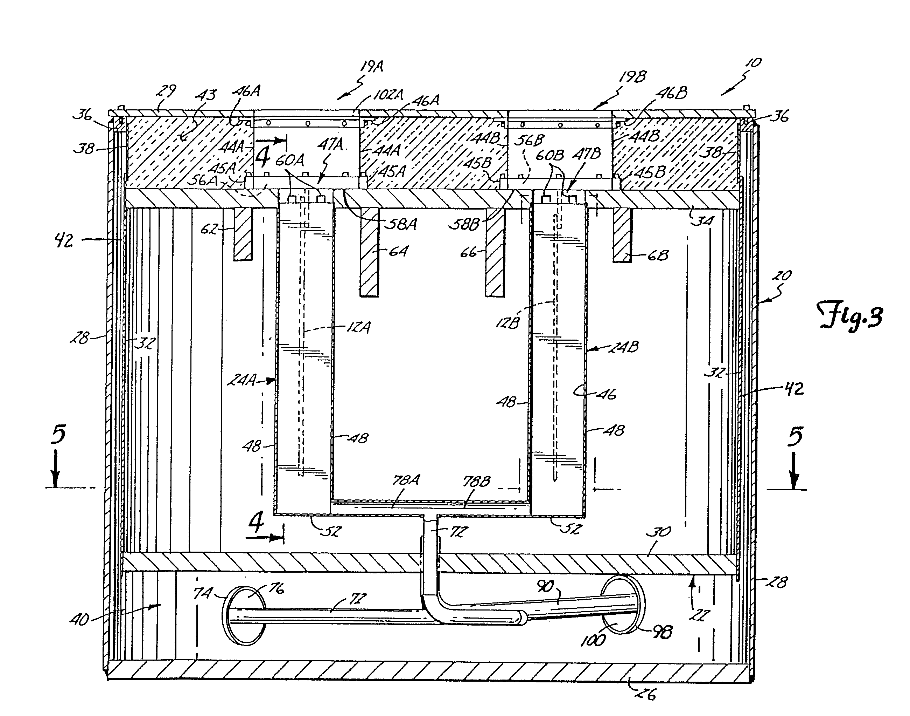

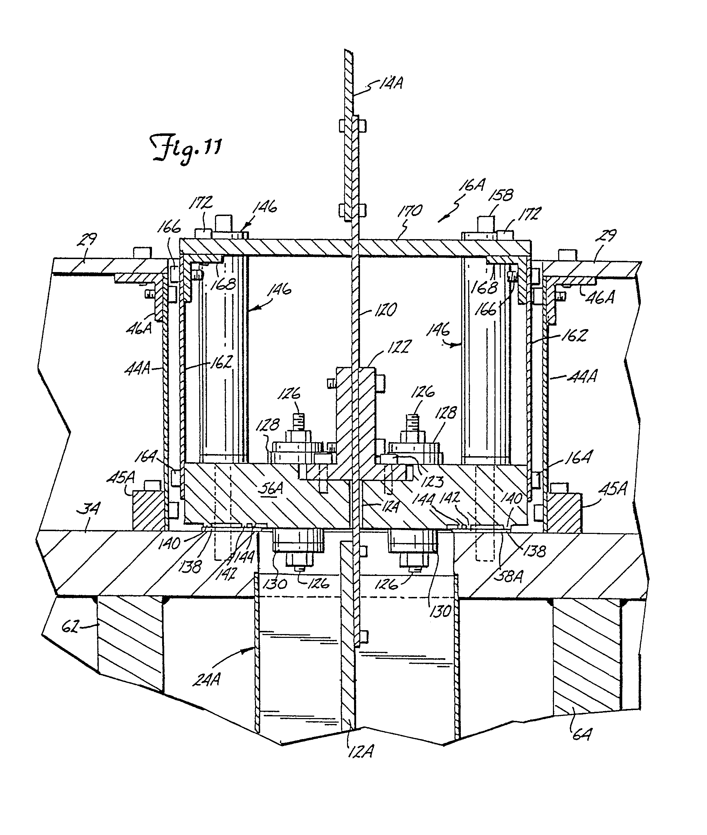

A cryostat 10 according to the present invention and shown in perspective view in Figure 1 cools central processor (CP) circuit boards 12A,12B (shown in phantom lines in Figure 3) to cryogenic temperatures (for example 77°K). The CP circuit boards 12A,12B are connected to central processor memory (CPM) boards 14A,14B, respectively, through seal boards 120 (shown in Figures 2 and 11). Each CPM board 14A,14B has a plurality of central processor memory modules 18 mounted on it. Each central processor memory module 18 contains a stack of circuit boards carrying integrated circuit computer memory chips. Seal block assemblies 16A,16B are positioned within cavities 19A,19B (Figure 2), respectively, at the top end of the cryostat 10.

As best shown in Figure 3, the cryostat 10 has a cylindrical outer shell 20, a cylindrical inner shell 22 and a pair of CP containment vessels 24A,24B. The outer shell 20 is formed by a base plate 26, a cylindrical outer side wall 28, and an outer shell top plate 29. The inner shell 22 is formed by a bottom plate 30, a cylindrical inner side wall 32 and an inner shell top plate 34. The outer shell 20 and inner shell 22 are joined together in a concentric arrangement by a mounting ring 36 and a thermal isolation support ring 38. Together, the inner and outer shells 20,22 define a vacuum chamber 40, which provides thermal isolation between the interior of the inner shell 22 (which is at liquid nitrogen temperature 77°K during operation) and the environment surrounding the outer shell 20 (which is typically at about room temperature). Super insulation 42 is formed on the outer surface of the inner side wall 32 to reduce radiation losses. The super insulation 42 is formed by alternating layers of reflective and insulating material, and performs optimally in vacuum enviornments.

Thermal conduction between the inner shell 22 and the outer shell 20 is minimised by the thermal isolation support ring 38 and insulating foam 43. The inner shell 22 is suspended from the mounting ring 36, and thus from the outer shell 20 by the thermal isolation support ring 38. In one embodiment of the present invention, the thermal isolation support ring 38 is thin (0.51mm or 0.020 inch) stainless steel, which is a relatively poor conductor of heat, yet provided sufficient structural strength to suspend the inner shell 22 within the outer shell 20. The insulating foam 43 fills the space between the top plates 29,34 and between the thermal isolation support ring 38 and side walls 44A,44B which define cavities 19A,19B respectively. Because physical contact between the outer shell 20 and inner shell 22 is through the thermal isolation support ring 38 and the insulating foam 43, the conductive heat transfer between the top plate 34 of the inner shell 22 and the top plate 29 of the outer shell 20 is minimised.

The side walls 44A (which define the cavity 19A) in which the seal block assembly 16A is positioned) are attached at their lower ends to mounting bars 45A on the top plate 34 of the inner shell 22. Similarly the side walls 44B (which define the cavity 19B in which the seal block assembly 16B is positioned) are attached at their lower ends to mounting bars 45B on the top plate 34 of the inner shell 22.

The upper ends of the side walls 44A,44B are connected to brackets 46A,46B, respectively, which in turn are attached to the bottom surface of the top plate 29 of the outer shell 20. The side walls 44A,44B are of a low thermal conductivity material, such as G10 epoxy, to minimise conductive heat transfer.

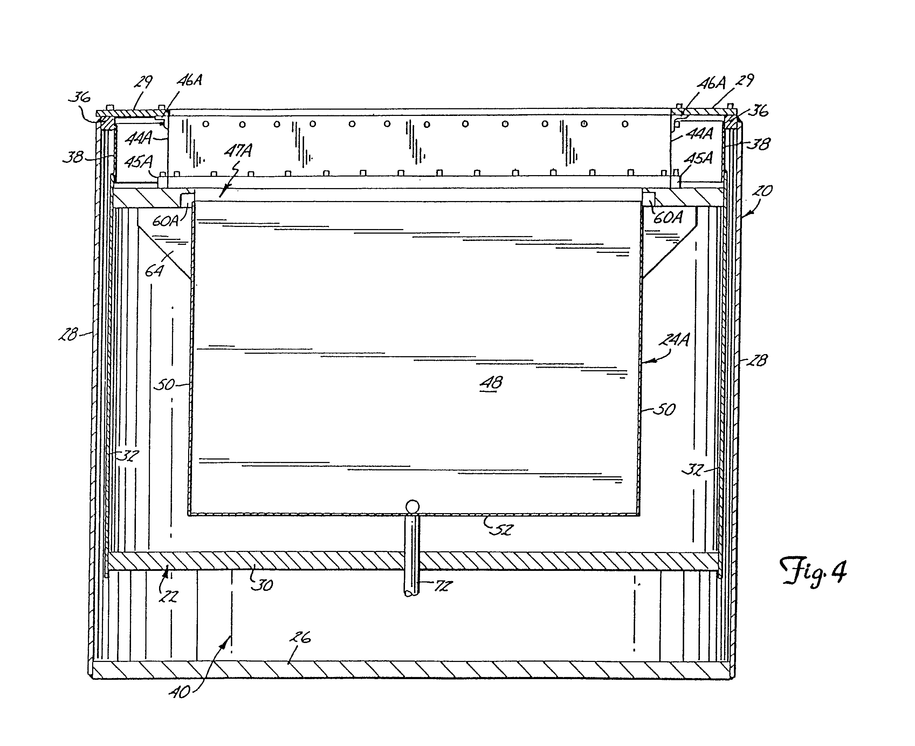

The top plate 34 of the inner shell 20 has a pair of rectangular openings 47A,47B which are located at the bottom of the cavities 19A,19B. respectively. The container vessels 24A,24B are mounted within the inner shell 22 below the openings 47A,47B, respectively. Each containment vessel 24A,24B has a pair of side walls 48, a pair of end walls 50 (Figure 4), and a bottom plate 52.

When the CP circuit board 12A,12B is installed within the containment vessel 24A,24B, cover plates 56A,56B of the seal block assembly 16A,16B seal against machined flat surface seal areas 58A,58B (Figure 3) which surround the opening 47A,47B, respectively. Overflow vents 60A.60B in the top plate 34 of the inner shell provide a path for escape of liquid nitrogen and nitrogen gas from the interior of the containment vessels 24A,24B, respectively, to the interior of the inner shell 22. The cover plates 56A,56B prevent the escape of liquid nitrogen or nitrogen gas through the top ends of the opening 47A,47B.

Stiffeners 62,64,66,68 are mounted on the bottom surface of the top plate 34 of the inner shell with the stiffeners 62,64 positioned on opposite sides of the containment vessel 24A and the stiffeners 66,68 positioned on opposite sides of the containment vessel 24B. The stiffeners 62,64,66,68 prevent deflection of the top plate 34 so that the seal areas 58A,58B remain flat, and reliable seals can be made between the cover plates 56A,56B and the top plate 34 of the inner shell.

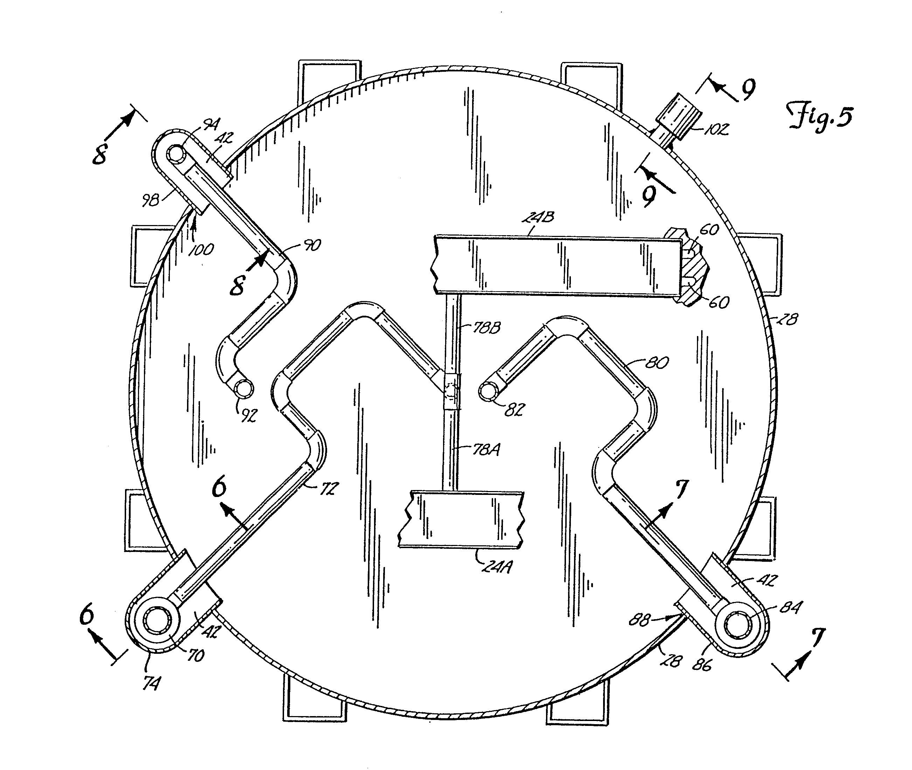

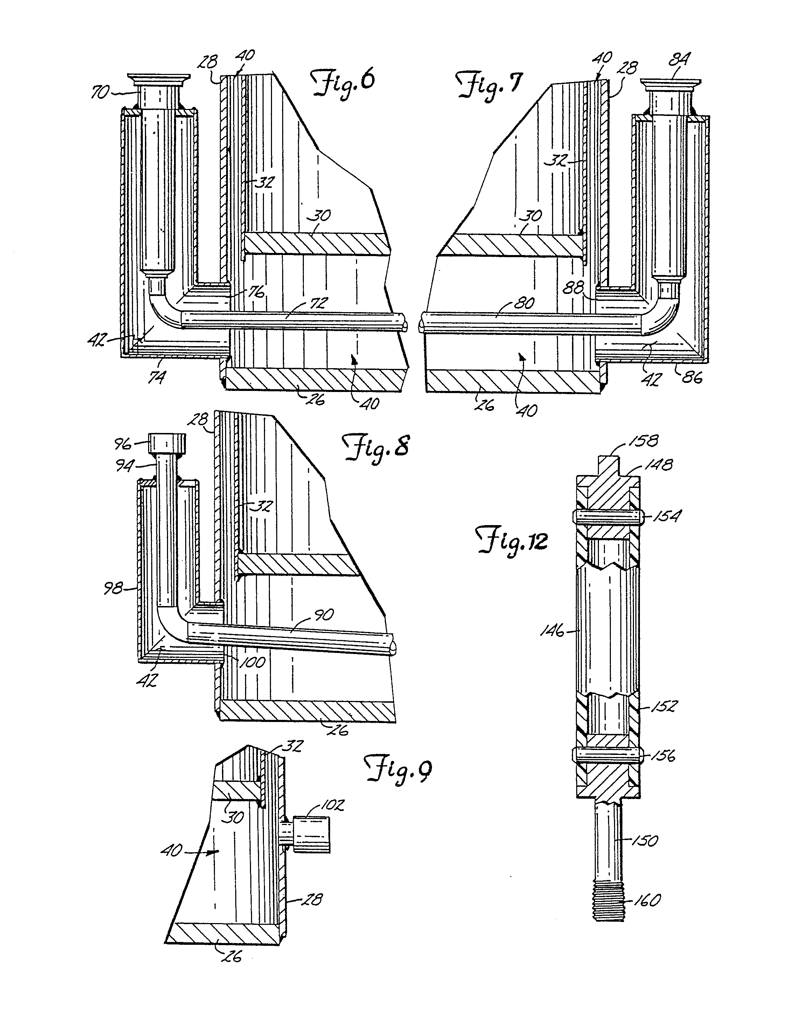

Liquid nitrogen from a liquid nitrogen source (not shown) is received at an inlet coupling 70 (Figure 1) and is supplied through a supply tube 72 to the bottom ends of the containment vessels 24A,24B. As best shown in Figures 5 and 6, the inlet coupling 70 is a female bayonet coupling, which is clamped by a Marmand clamp (not shown) when connection is made to the liquid nitrogen source. A pants leg 74 is sealed around the inlet coupling 70 and is connected to the side wall 28. The supply tube 72 connects to the lower end of the inlet coupling 70 within the pants leg 74 and extends through an opening 76 in the side wall 28. The supply tube 72 enters the interior of the inner shell 22 through the bottom plate 30 and forms a "T", with a leg 78A being connected to the containment vessel 24A and a leg 78B being connected to the containment vessel 24B.

A return line 80 has its inlet end 82 open to the interior of the inner shell 22 and its outlet end connected to an outlet coupling 84. The return line 80 receives nitrogen gas and liquid which has been received in the interior of the inner shell 22 after it has escaped from one of the containment vessels 24A,24B through the overflow vents 60A,60B. The gas and liquid flows out through the return line 80 to the outlet coupling 84, and then back to the liquid nitrogen source. A pants leg 86 surrounds and is sealed to the outlet coupling 84, and is connected to the side wall 28 at an opening 88.

A pressure relief line 90 (shown in Figures 5 and 8) also communicates with the interior of the inner shell 22. An inlet end 92 of the pressure relief line 90 extends through the bottom plate 30 and into the interior of the inner shell 22, while an outlet end 94 of the pressure relief line 90 is connected to a coupling 96 (Figure 8). A pressure relief valve (not shown) is connected to a coupling 96. A pants leg 98 surrounds and is sealed to the outlet end 94 of the pressure relief line 90 and is connected to the side wall 28 at an opening 100.

In one embodiment of the present invention, bulk insulation such as glass wool is applied to the inner surfaces of the pants legs 74,86,98.

Also mounted on the side wall 28 is a vacuum seal off valve 102 (see Figures 5 and 9). The vacuum chamber 40 is initially evacuated through the valve 102.

Each seal block assembly 16A,16B is located within a respective one of the cavities 19A,19B defined by the top plate 34 of the inner shell, the top plate 29 of the outer shell and the side walls 44A,44B. The seal block assemblies 16A,16B must perform several important functions. Firstly, they must provide a seal at the upper end of the containment vessels 24A,24B. Secondly, they must provide thermal insulation between the interiors of the containment vessels 24A,24B (which are at liquid nitrogen temperature) and the CPM boards 14A,14B which are at or very near room temperature. Thirdly, they must provide feed-throughs for electrical power to the CP circuit boards 12A,12B. Fourthly, they must be removable in order to permit removal, replacement or repair of the CP circuit boards 12A,12B.

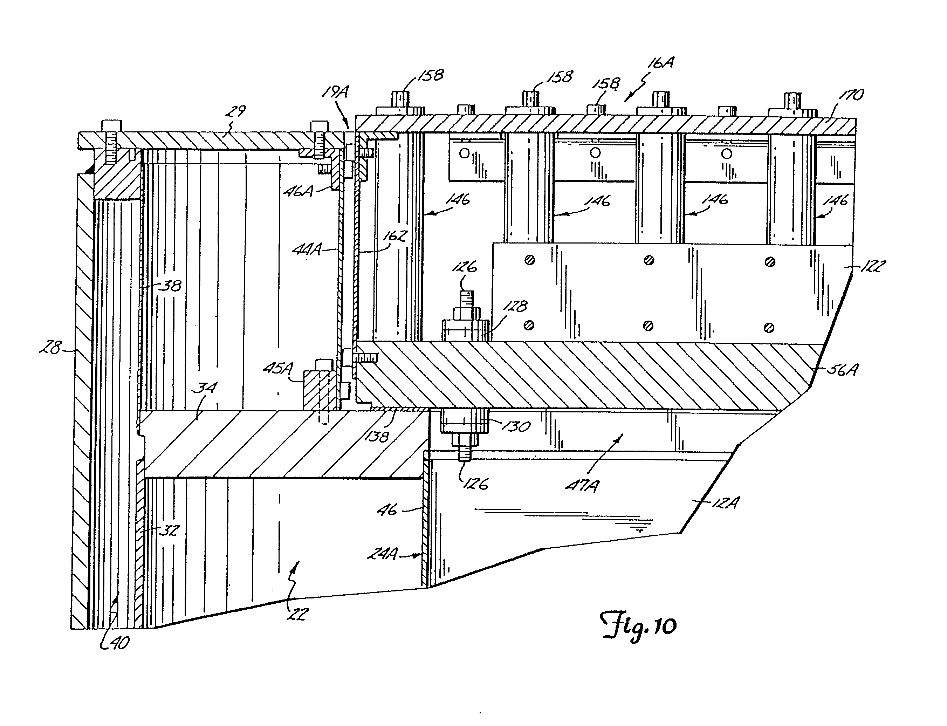

Figures 10 and 11 show the seal block assembly 16A in further detail: it will be appreciated that the seal block assembly 16B is similar in construction. Electrical connection between the CP circuit board 12A and the CPM board 14A is provided by the seal board 120. The upper end of the CP circuit board 12A is attached to the lower end of the seal board 120, and the lower end of the CPM board 14A is attached to the upper end of the seal board 120. A feed-through clamp 122 holds the seal board 120 in position, and is clamped by bolts 123 to the cover plate 56A. The seal board 120 extends through an opening 124 in the cover plate 56A. Power bus terminals 126 extend through the cover plate 56A to provide a feed-through connection of power to the CP circuit board 12A. Insulator blocks 128,130 provided electrical insulation of the terminals 126 from the cover plate 56A.

A polytetrafluroethylene (TEFLON - Trade Mark) gasket 138 surrounds the opening 47A and is positioned between the seal area 58A and the cover plate 56A. In the embodiment shown in Figure 11, the cover plate 56A includes a plurality of pressure point ridges 140,142,144 which apply pressure to the gasket 138.

The cover plate 56A is clamped down against the top plate 34 by bolts 146. Figure 12 shows a preferred embodiment of one of the bolts 146. In this embodiment, each bolt 146 has a metal upper end 148, a metal lower end 150, and a thermally insulating plastics sleeve 152. A pin 154 joins the sleeve 152 to the upper end 148, and a pin 156 joins the sleeve 152 to the lower end 150. The upper end 148 has a hex head 158 which is used for tightening and removing the bolt 146. The lower end 150 has a threaded shank 160 which extends into a threaded hole in the top plate 34. The bolt 146 provides high clamping forces while avoiding a high thermal conductivity path from the top plate 34 to the exterior of the cryostat 10.

The seal block assembly 16A has side walls 162 which are attached at their lower ends by screws 164 to the cover plate 56A. At their upper ends, the walls 162 are attached by screws 166 to brackets 168. A top panel 170 of the seal block assembly 16A is connected to the brackets 168 by screws 172.

The cryostat illustrated in the drawings has a number of important advantages. First, the cylindrical construction of the outer and inner shells 20,22 provides an easily fabricated construction for the vacuum chamber. Because of the cylindrical configuration, relatively lightweight metals can be used for the side walls of the shells 20,22.

Second, the use of rectangular shaped containment vessels 24A,24B within the inner shell 22 provides a minimum volume for the liquid nitrogen because the rectangular configuration conforms to the shape of the CP circuit boards 12A,12B. This reduces the amount of liquid nitrogen which must be used (in contrast to having to fill the entire volume of the inner shell 22).

Third, the inner shell 22 shields the containment vessels 24A,24B from the outer shell 20, and therefore the entire mass of the cryostat 10 does not have to be cooled down and warmed up each time a CP circuit board 12A,12B is removed for replacement or maintenance.

Fourth, because the interior of the containment vessels 24A,24B is at the same pressure as the exterior (i.e. the interior of the inner shell 22) the walls of the containment vessel 24A,24B can be of relatively lightweight construction. This lightweight construction also contributes the faster heating up and cooling down of the containment vessels 24A,24B.

Fifth, the cryostat 10 provides relatively short signal paths between the CP circuit boards 12A,12B and the corresponding CPM boards 14A,14B so that high operating speeds can be achieved. At the same time, a large temperature differential with minimum thermal losses is maintained between the CP circuit boards 12A,12B and the CPM boards 14A,14B.

## Claims

1. A cryostat characterised by comprising: an outer shell (20) having a side wall (28) and a closed bottom (26); an inner shell (22) positioned within the outer shell (20), the inner shell having a side wall (32), a closed bottom (30) and an open top; connecting means (36,38) for connecting the inner and outer shells (20,22) to define a vacuum chamber (40) therebetween; an inner shell top plate (34) covering the open top end of the inner shell (22) and having a first opening therein (47A,47B); a first containment vessel (24A,24B) mounted below the inner shell top plate (34) and within an interior of the inner shell (22) for receiving a first device (12A,12B) to be cooled; supply means (70,72) connected to the first containment vessel (24A,24B) for supplying liquid cryogenic coolant thereto; and suspension means (16A,16B) for suspending the device in the first containment vessel while covering the first opening (47A,47B) and while providing transmission of signals to and from the first device.

2. A cryostat as claimed in claim 1 characterised in that the outer shell (20) and the inner shell (22) are cylinders of generally circular cross-section.

3. A cryostat as claimed in claim 1 or 2 characterised in that the outer shell (20) and the inner shell (22) are substantially concentrically positioned.

4. A cryostat as claimed in any preceding claim characterised in that the containment vessel (24A,24B) is of substantially rectangular cross-section.

5. A cryostat as claimed in claim 4 characterised in that the device to be cooled is a circuit board having first and second generally parallel major surfaces, the first containment vessel having first and second side walls which are generally parallel to the first and second major surfaces of the circuit board.

6. A cryostat as claimed in any preceding claim characterised in that the connecting means is a thermal isolation ring (38) which extends between the outer shell (20) and the inner shell (22).

7. A cryostat a claimed in claim 6 characterised in that the thermal isolation ring (38) is connected at its upper end to the outer shell (20) and is connected at its lower end to the inner shell (22).

8. A cryostat as claimed in any preceding claim characterised by an outer shell top plate (29) mounted on the outer shell (20) and covering a top end of the outer shell, the outer shell top plate having a first opening (19A,19B) positioned over the first opening (47A,47B) in the inner shell top plate.

9. A cryostat as claimed in claim 8 characterised by including a cavity between the first opening (47A,47B) of the outer shell top plate (29) and the first opening of the inner shell top plate (34) for receiving the suspension means.

10. A cryostat as claimed in claim 9 characterised by thermal insulation means (43) positioned between the outer top shell plate (29) and the inner shell top plate (34) and generally surrounding the cavity.

11. A cryostat as claimed in any preceding claim characterised in that the suspension means (16A,16B) includes a cover (56A,56B), means (120,126) extending through the cover for providing transmission of signals to and from the device; and mounting means (146) for attaching the cover (56A,56B) to the inner shell top plate (34) to cover the first opening (47A,47B).

12. A cryostat as claimed in claim 11 characterised in that the mounting means (146) comprises a plurality of bolts, each bolt having an upper end (148) with a head (158), a lower end (150) with a threaded shank (160) and a thermally insulating sleeve (152) connecting the upper end and the lower end.

13. A cryostat as claimed in claim 11 or 12 characterised in that the means for providing transmission of signals is a seal board (120) which extends through and is sealed to the cover (56A,56B), and is connected at its lower end to an upper end of the device.

14. A cryostat as claimed in any preceding claim characterised in that the supply means comprises an inlet coupling (70) exposed at an exterior of the cryostat, and means (72) extending from the inlet coupling through the inner shell (22) to the first containment vessel (24A,24B).

15. A cryostat as claimed in claim 14 characterised by a pants leg (74) surrounding and sealed to the inlet coupling (70) at a first end and connected at a second end to the side wall (28) of the outer shell (20).

16. A cryostat as claimed in any preceding claim characterised by overflow vent means (60A,60B) for providing a passage for the coolant from the first containment vessel (24A,24B) to the interior of the inner shell (22), and drain means (90) connected to the inner shell (20) to remove coolant from therewithin.

17. A cryostat as claimed in any preceding claim characterised by a second opening (47A,47B) in the inner shell top plate (34) substantially parallel to the first opening, a second containment vessel (24A,24B) mounted below the inner shell top plate (34) and within the interior of the inner shell for receiving a second device (12A,12B) to be cooled, the supply means (70,72) being connected to the second containment vessel for supplying liquid cryogenic coolant thereto, and second mounting means (16A,16B) for suspending the second device to be cooled in the second containment vessel while covering the second opening (47A,47B) and while providing transmission of signals to and from the second device.

18. A cryogenically cooled computer system characterised by comprising: a central processor circuit board (12A,12B) having a plurality of integrated circuits mounted thereon which form a computer central processor; a central processor memory (14A,14B) having a plurality of memory elements (18) which are associated with the central processor; a cryostat (10) having a containment vessel (24A,24B) for receiving the central processor circuit board and having inlet supply means (70) for supplying liquid cryogenic coolant to the containment vessel to cool the central processor circuit board to a cryogenic temperature; and mounting means (16A,16B) connected to the central processor circuit board and the central processor memory for suspending the central processor circuit board within the containment vessel, the mounting means including means (56A,56B) for sealing the containment vessel from the exterior of the cryostat, means (120) for providing transmission of signals between the central processor circuit board and the central processor memory, and power feed-through means (126) for providing electrical power to the central processor circuit board.

19. A computer system as claimed in claim 18 characterised in that the cryostat (10) includes an outer shell (20), an inner shell (22) position within the outer shell, and connecting means (36,38) for connecting the inner and outer shells (20,22) to define a vacuum chamber (40) therebetween, the containment vessel (24A,24B) being mounted within an interior of the inner shell.

20. A computer system as claimed in claim 18 or 19 characterised by overflow vent means (60A,60B) for providing a passage for the coolant from the containment vessel (24A,24B) to the interior of the inner shell (22).

21. A computer system as claimed in any of claims 18 to 20 characterised by frame means (90) connected to the inner shell (22) to remove coolant from therewithin.

22. A computer system as claimed in claim 19 or claims 20 or 21 when dependent thereon characterised in that the outer shell (20) and inner shell (22) are cylinders of substantially circular cross-section.

23. A computer system as claimed in claim 22 characterised in that the outer shell (20) and the inner shell (22) are substantially concentrically positioned.

24. A computer system as claimed in claim 22 or 23 characterised in that the containment vessel (24A,24B) is of substantially rectangular cross-section.

25. A computer system as claimed in claim 19 or any of claims 20 to 24 when dependent thereon characterised in that the connecting means is a thermal isolation ring (38) which is connected at its upper end to the outer shell (20) and at its lower end to the inner shell (22).

26. A computer system as claimed in any of claims 18 to 25 characterised in that the integrated circuits are CMOS integrated circuits.

*Fig.1*

Fig.2

Fig.3

Fig. 4

0 274 263

Fig.5

Fig.6

Fig.7

Fig.8

Fig.9

Fig.12

Fig. 10

0 274 263

Fig. 11